# EUROPÄISCHE PATENTSCHRIFT

(11) **EP 2 410 829 B1**
(45) Veröffentlichungstag und Bekanntmachung des Hinweises auf die Patenterteilung: **24.10.2012**
(21) Anmeldenummer: 10170111.8
(22) Anmeldetag: 20.07.2010
(51) Int. Cl.: H05K 7/20

(54) **Kühlsystem für eingehauste elektronische Geräte**
Cooling system for housed electronic equipment
Système de refroidissement pour appareils électroniques encastrés

(43) Veröffentlichungstag der Anmeldung: 25.01.2012
(73) Patentinhaber: JM Kunststoffe Produktions-und-Vertriebs-GmbH & Co KG, 13403 Berlin (DE)
(72) Erfinder: Söhngen, Karlheinz, 15837 Baruth/Mark (DE); Hinz, Thorsten, 12359 Berlin (DE)
(74) Vertreter: Schwabe - Sandmair - Marx

(56) Entgegenhaltungen:
- EP-A2- 2 053 911
- US-A1- 2006 232 945
- US-A1- 2009 225 513

## Beschreibung

Die Erfindung betrifft ein Kühlsystem zur Kühlung von Abwärme produzierenden elektronischen Geräten, insbesondere von Campufier-Racks.

Um die Funktion elektronischer Geräte sicherzustellen, müssen diese gekühlt und die produzierte Abwärme abgeführt werden. Bei bekannten Server-Racks wird die Kühlluft aus dem Serverraum angesaugt, zur Kühlung an den elektronischen Geräten vorbeigeführt und mittels eines Gebläses oder Ventilators wieder in den Serverraum ausgeblasen. Daher entsteht in Serverräumen von Datenzentren eine hohe Wärmebelastung durch die von den Servern produzierte Abwärme. Bisher erfolgt die Wärmeabfuhr aus solchen Räumen durch den Abtransport der erwärmten Luft. Da Luft allerdings ein sehr schlechter Wärmeleiter ist, müssen sehr hohe Luftmassenströme umgewälzt werden, um die notwendige Kühlleistung zu erbringen. Die Transportleistung für die Umluft bzw. die Antriebsleistung der Ventilatoren und die Rückkühlung der Umluft durch Kältemaschine stellen einen erheblichen Kostenfaktor für Datenzentren dar.

Es ist die Aufgabe der vorliegenden Erfindung, eine effizienter Kühlung für eingehauste elektronische Geräte, insbesondere für Computer-Racks bereitzustellen.

Diese Aufgabe wird vom Gegenstand des Patentanspruchs 1 gelöst. Die Unteransprüche definieren dabei bevorzugte Ausführungsformen der vorliegenden Erfindung.

Obwohl die vorliegende Erfindung im Folgenden als zur Kühlung von Server-Racks verwendet beschrieben wird, ist es durchaus vorstellbar, auch andere Abwärme produzierende Geräte mit dem erfindungsgemäßen Kühlsystem zu kühlen.

Das erfindungsgemäße Kühlsystem umfasst einen Wärmetauscher und eine geschlossene und sich zumindest zwischen der Hausung der Geräte und dem Wärmetauscher erstreckenden Kühlluftführung, welche die aus der Hausung austretende erwärmte Kühlluft dem Wärmetauscher zuführt, bevor diese an die Umgebung abgegeben wird.

Mit anderen Worten wird gemäß der vorliegenden Erfindung die erwärmte Kühlluft vom Gebläse aus der Gerätehausung nicht mehr in den Serverraum geblasen, sondern die erwärmte Kühlluft wird unmittelbar zu einem Wärmetauscher geführt, wo der Kühlluft die Wärme wieder entzogen wird. Erst die gekühlte Luft wird dann wieder in den Serverraum eingeblasen.

Die Wärme wird gemäß der vorliegenden Erfindung also direkt dort abgeführt, wo sie entsteht. Die Luft im Serverraum wird somit nicht mehr erwärmt, und muss demnach nicht erst wieder aufwendig gekühlt werden. Auf diese Weise kann die Energie, welche für den Transport der Luft aus dem Serverraum zu einer Kältemaschine hin und von dieser wieder zurück in den Serverraum notwendig ist, eingespart werden.

Ein weiterer Vorteil der vorliegenden Erfindung besteht darin, dass sie die ohnehin vorhandenen Kühlgebläse des Servers nutzt, um die Kühlluft am Wärmetauscher vorbeizuführen. Somit muss für das erfindungsgemäße Kühlsystem kein eigenes Gebläse bereitgestellt werden, was den Energieaufwand für die Kühlung weiter reduziert. Selbstverständlich ist es jedoch vorstellbar, ein zusätzliches Gebläse vorzusehen, um beispielsweise einen höheren Druckverlust beim Durchströmen des Wärmetauschers durch die Kühlluft auszugleichen.

Gemäß einer bevorzugten Ausführungsform wird der Wärmetauscher von einem flüssigen Kühlmedium durchströmt. Wasser als Kühlmedium ist dabei besonders kostengünstig, wobei es durchaus vorstellbar ist, diesem Additive, wie beispielsweise Frostschutzmittel zuzusetzen. Selbstverständlich sind auch andere flüssige Kühlmedien geeignet, im erfindungsgemäßen Kühlsystem eingesetzt zu werden.

Während bei bisherigen Kühlsystemen die durch die Geräte erwärmte und aus dem Serverraum abtransportierte Luft vor deren Rücktransport in den Serverraum erst energieaufwendig durch Kältemaschinen wieder rückgekühlt werden muss, reicht es bei der vorliegenden Erfindung aus, das im Wärmetauscher erwärmte flüssige Kühlmedium außerhalb des Serverraums in einem weiteren Wärmetauscher rückzukühlen. Dies kann beispielsweise in einem nassen oder trockenen Kühlturm geschehen, was den Einsatz von energieaufwendigen Kältemaschinen fast ganzjährig überflüssig macht.

Gemäß einer weiteren bevorzugten Ausführungsform wird der Wärmetauscher vom Kühlmedium quer zur Strömungsrichtung der erwärmten Luft durchströmt. Es handelt sich also um einen Kreuzstrom-Wärmetauscher. Versuche haben gezeigt, dass es sich hierbei um eine zweckmäßige Bauart für die vorliegende Erfindung handelt.

Bisherige Server-Racks werden nämlich in horizontaler Richtung von Kühlluft durchströmt, während bei einer besonders bevorzugten Ausführungsform der vorliegenden Erfindung der Wärmetauscher auf der Rückseite der Gerätehausung bzw. des Server-Racks, an welcher die erwärmte Kühlluft ausströmt, vorgesehen ist. Da sich die Dichte des Kühlmediums im Wärmetauscher mit steigender Temperatur verringert und das Kühlmedium danach bestrebt ist, in vertikaler Richtung nach oben zu steigen, wird bei vertikaler Anordnung der Kühlmediumführung der Transport des Kühlmediums durch dessen natürlichen Auftrieb unterstützt. Somit ist bei einem rückseitig am Server-Rack angeordneten Wärmetauscher die Kreuzstrombauweise die geeignetste. Es ist jedoch ebenfalls denkbar, den Wärmetauscher an anderer Stelle der Gerätehausung anzuordnen, wie beispielsweise an der Ober- oder Unterseite des Server-Racks, so dass sich auch Gegenstrom- bzw. Gleichstrombauweisen als geeignet herausstellen können. Es ist ferner vorstellbar, den Wärmetauscher an einer anderen Stelle wie die Gerätehausung bzw. das Server-Rack vorzusehen, solange die aus der Gerätehausung austretende erwärmte Kühlluft auf direktem Weg zum Wärmetauscher transportiert wird, um erst nach dem Passieren des Wärmetauschers wieder gekühlt in den Serverraum abgegeben zu werden. Hierzu wäre beispielsweise ein sich vom Server-Rack zum Wärmetauscher erstreckender Kühlluftschlauch vorstellbar.

Besonders bevorzugt kommen beim erfindungsgemäßen Wärmetauscher Kapillarrohre für die Führung des Kühlmediums zum Einsatz. Auf diese Weise generiert der Wärmetauscher nur einen sehr geringen Druckverlust in der Kühlluftströmung, so dass ein ausreichender Kühlluftstrom alleine durch das im Server vorhandene Gebläse aufrechterhalten werden kann und ein separates Gebläse zum Ausgleich des Druckverlusts im Wärmetauscher nicht zwingend notwendig ist. Ebenso vorteilhaft ist der Wärmetauscher mit Kapillarrohren verschmutzungsunanfällig und somit äußerst wartungsfreundlich.

Weiter bevorzugt können mehrere Kapillarrohre zu einem Verbund zusammengefasst werden, wobei die Kapillarrohre parallel geschaltet sein können und demnach einen gemeinsamen Zulauf und einen gemeinsamen Ablauf aufweisen. Es wäre jedoch auch denkbar, die Kapillarrohre eines Verbunds seriell zu schalten, so dass diese vom Kühlmedium nacheinander durchlaufen werden.

Des Weiteren ist eine flächige Ausgestaltung des Kapillarrohr-Verbunds bevorzugt, bei der sich die Kapillarrohre eines Verbunds parallel in einer Ebene erstrecken. Eine solche Ausgestaltung wird auch als Kapillarrohrmate bezeichnet.

Der erfindungsgemäße Wärmetauscher kann gemäß einer besonders bevorzugten Ausführungsform mehrere solcher Verbunde aufweisen, die zu einem Register zusammengefasst sind. Dabei ist es möglich, einzelne, mehrere oder alle Verbunde parallel und/oder seriell zu schalten. Besonders bevorzugt wird jedoch eine parallele Schaltung der Verbunde, so dass diese vom Kühlmedium gleicher Temperatur durchströmt werden. Bevorzugt wird ebenfalls eine sich quer zur Strömungsrichtung der Kühlluft erstreckende Ausrichtung der Verbunde, so dass der Kühlluftstrom die einzelnen Verbunden nach dem Austritt aus dem Server-Rack nacheinander passiert. Denkbar wäre allerdings ebenso eine Ausrichtung der Verbunde, bei der die einzelnen Verbunde parallel von der Kühlluft angeströmt werden, die Strömung der Kühlluft also in der Ebene der einzelnen Verbunde verläuft.

Sofern gemäß einer weiteren bevorzugten Ausführungsform die Kühlmediumführung, insbesondere die Kapillarrohre einen Kunststoff, insbesondere Polypropylen (PP), Polyethylen (PE), Polyester oder Polyethylenterephtalat (PET) umfassen, kann die Wartungsfreundlichkeit des erfindungsgemäßen Kühlsystems weiter verbessert werden, da die Kapillarrohre aus Polypropylen korrosionsbeständig sind und somit auch keine Verstopfungen dieser durch Rostpartikel befürchtet werden müssen. Ebenso sind solche Kapillarrohre schmutzabweisend, so dass der Wärmetauscher auch nicht so leicht durch mit der Kühlluft eingebrachten Schmutz verstopfen kann. Besonders bevorzugt werden demnach vollständig aus Polypropylen gefertigte Kapillarrohre.

Des Weiteren kann der Wärmetauscher des erfindungsgemäßen Kühlsystems von einem Gehäuse umgeben sein, welcher mit der Hausung der zu kühlenden Geräte bzw. dem Server-Rack verbunden ist. Wie weiter oben schon angedeutet, kann das Gehäuse des Wärmetauschers hierbei an einer beliebigen Stelle der Gerätehausung angebracht sein, wobei eine rückwärtige Anordnung des Wärmetauschergehäuses am Server-Rack besonders bevorzugt ist. Um den Zugang und somit auch die Wartungsfreundlichkeit des Wärmetauschers zu verbessern, kann das Wärmetauschergehäuse schwenkbar an der Gerätehausung angebracht sein, so dass der Wärmetauscher samt Gehäuse für Wartungszwecke von der Gerätehausung weggeschwenkt werden kann.

Gemäß einer weiter bevorzugten Ausführungsform weist das Wärmetauschergehäuse in Strömungsrichtung der erwärmten Luft im Wesentlichen den gleichen Querschnitt auf wie die Gerätehausung. Mit anderen Worten weist das Wärmetauschergehäuse die entsprechenden Abmaße der jeweiligen Seite an der Gerätehausung auf, an welcher das Wärmetauschergehäuse mit dem Wärmetauscher angebracht ist.

Die vorliegende Erfindung wird im Folgenden anhand der Figuren 1 bis 3 näher erläutert. Sie kann darin gezeigte Merkmale einzeln sowie in jedweder sinnvollen Kombination umfassen.

Es zeigen:
- Fig. 1:: eine schematische Seitenansicht des erfindungsgemäßen Kühlsystems an einem Server-Rack
- Fig. 2:: eine Seitenansicht eines Kapillarrohr-Verbunds
- Fig. 3:: Drei-Seiten-Ansicht eines erfindungsgemäßen Wärmetauschers

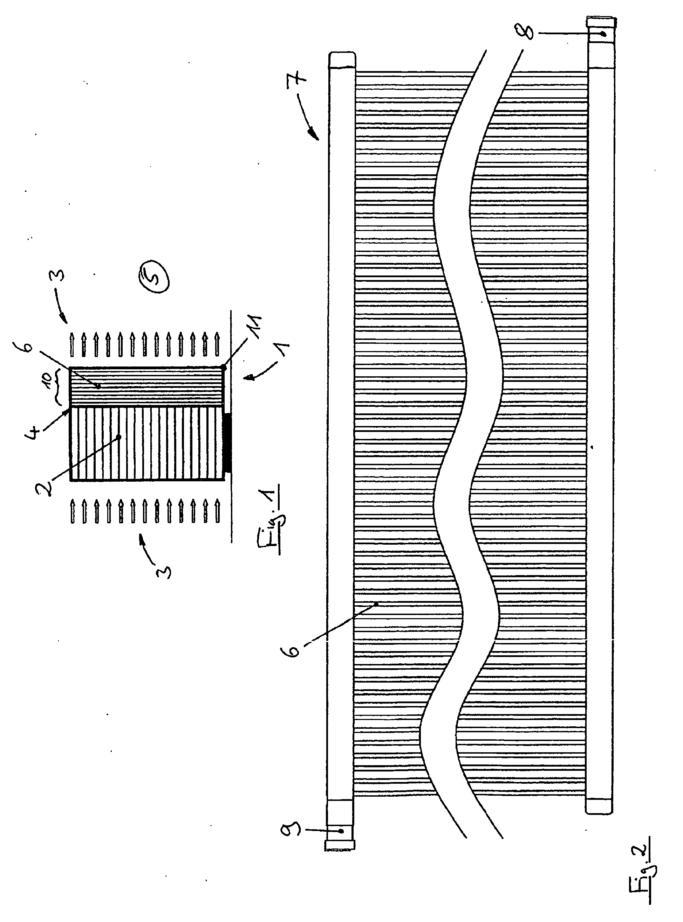

In der Figur 1 ist eine schematische Seitenansicht eines Server-Racks 2 mit einem daran angebrachten Wärmetauschergehäuse 11 gezeigt. Das Wärmetauschergehäuse 11 ist auf der Rückseite der Gerätehausung 2 angebracht und somit auf der Seite, auf welcher der durch die Vorderseite des Server-Racks 2 eintretende Luftstrom 3 wieder aus dem Server-Rack 2 austreten bzw. in die Umgebung/den Serverraum 5 eintreten würde. Die Strömung der Kühlluft 3 ist in der Figur 1 durch die parallelen Pfeile angedeutet. Der im Gehäuse 11 sitzende Wärmetauscher 1 umfasst ein aus mehreren parallel geschaltenen Kapillarrohrverbunden 6 gebildetes Register 10. Die Kühlluftführung 4 besteht in der hier gezeigten Ausführungsform aus einer zwischen Wärmetauschergehäuse 11 und Server-Rack 2 angeordneten, umfänglichen am Gehäuse 11 umlaufenden und eingeklebten Dichtlippe, welche einen luftdichten Anschluss von Server-Rack 2 und dem Wärmetauschergehäuse 11 ermöglicht.

Die internen, nicht gezeigten Kühlgebläse der Server 2 fördern die warme Abluft 3 der Geräte durch das mit Wasser durchströmte Kühlregister 10, in welchem der Luft 3 die Abwärme entzogen wird und auf das Kühlmedium Wasser übertragen wird. Das erwärmte Kühlwasser wird in einem geschlossenen Rohrkreislauf nach außen transportiert und dort rückgekühlt. Das erfindungsgemäße Kühlsystem ersetzt dabei die bisher übliche lüftungstechnische Anlage des Serverraums.

Nicht gezeigt sind zwischen Server-Rack 2 und Wärmetauschergehäuse 11 angebrachte ober- und unterseitige Halterungen mit Stiftscharnieren, welche für Wartungsarbeiten an den Servern und/oder am Kühlregister ein Wegschwenken des Wärmetauschergehäuses 11 vom Server-Rack 2 erlauben, ohne dass die Anschlüsse für das Kühlmedium demontiert werden müssen.

In der Figur 2 ist ein flächiger Verbund 7, eine sogenannte Kapillarrohrmatte mit mehreren Kapillarrohren 6 gezeigt, die sich in einer vertikalen Richtung parallel zwischen zwei Verteilerstämmen erstrecken. Die Länge der Kapillarrohre 6 richtet sich nach der entsprechenden Höhe des Rackgehäuses. Der untere Verteilerstamm weist einen Zulauf 8 auf, während der obere Verteilerstamm einen Ablauf 9 aufweist. Im hier gezeigten Beispiel können dadurch flexible Anschlussschläuche DN15 mit dem Verbund 7 verbunden werden, so dass das Kühlwasser den Verbund 7 von unten nach oben durchströmt.

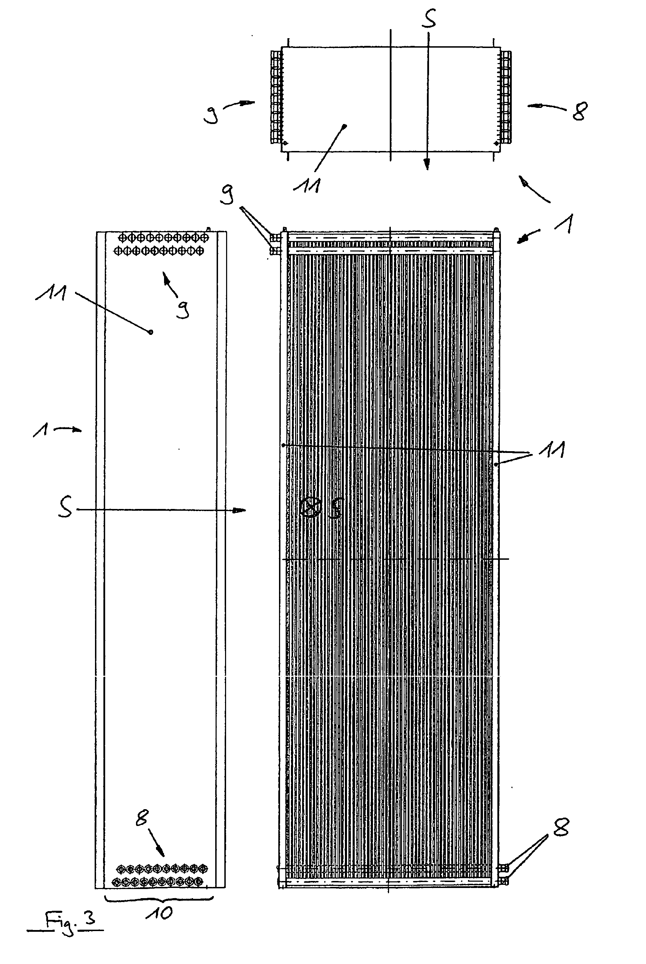

In der Figur 3 ist eine 3-Seiten-Ansicht eines erfindungsgemäßen Wärmetauschers 1 gezeigt, der ein Register 10 aus 20 Kapillarrohrmatten 7 und ein Wärmetauschergehäuse 11 umfasst, welches das Kapillarrohrmattenregister 10 an vier Seiten umgibt und die in Richtung S verlaufende Kühlluftströmung 3 durch das Register 10 hindurchführt. Im Stahlblechgehäuse 11 des Wärmetauschers 1 sind Halterungsbohrungen vorgesehen, in welche die einzelnen Kapillarrohrmatten 7 eingehängt werden können, wobei das Gehäuse 11 an der Ankoppelungsseite zwischen Server-Rack 2 und Wärmetauscher 1 als Flansch ausgebildet ist. Zu sehen sind ferner die Zuläufe 8 und die Abläufe 9, welche für jede Kapillarrohrmatte gesondert an gegenüberliegenden Seitenwandungen des Gehäuses 11 ausgebildet sind. Die für jede Kapillarrohrmatte gesondert vorgesehenen Zu- und Abläufe (8, 9) erlauben eine beliebige Schaltung der Kapillarrohrmatten 7, wobei eine parallele Schaltung der Kapillarrohrmatten 7 im Register 10 bevorzugt wird. Durch einen gewissen Höhenversatz der einzelnen Zu- und Abläufe (8, 9) ist es möglich, den Abstand zwischen den Kapillarrohrmatten 7 zu verringern, um ein kompakteres Register 10 zu erhalten.

In der konkreten Ausführungsform aus Figur 3 werden Kapillarrohrmatten des Herstellers Clina vom Typ Orimat G10 verwendet, dessen Kapillarrohre einen Außendurchmesser von 3,4 mm und einen Innendurchmesser von 2,3 mm aufweisen. Die Kapillarrohre sind aus Polypropylen gefertigt und mit einem oberen und einem unteren Verteilerstamm thermisch verschweißt. Das Achsmaß der Kapillaren untereinander beträgt hierbei 10 mm. Die Anzahl der Kapillarrohrmatten in einem Kühlregister ist hierbei variabel und kann an die tatsächliche Wärmeleistung eines Server-Racks angepasst werden. Die gezeigten Kapillarrohrmatten erreichen bei einer Wassereintrittstemperatur von ca. 18°C eine Kühlleistung von etwa 600 W pro Matte. Im hier gezeigten Beispiel sind 20 Kapillarrohrmatten 7 hintereinander angeordnet, deren Zuläufe und Abläufe parallel angeschlossen werden. Der hier gezeigte Wärmetauscher erreicht daher eine Gesamtkühlleistung von 12 KW. Mit abnehmenden Wassereintrittstemperaturen steigen die Kühlleistungen erheblich an.

## Patentansprüche

1. Kühlsystem für eingehauste elektronische Geräte, insbesondere Computer-Racks, mit einem Wärmetauscher (1) und einer geschlossenen und sich zumindest zwischen der Hausung (2) der Geräte und dem Wärmetauscher (1) erstreckenden Kühlluftführung (4), welche die aus der Hausung austretende erwärmte Kühlluft (3) dem Wärmetauscher (1) zuführt, bevor diese an die Umgebung (5) abgegeben wird, wobei der Wärmetauscher Kapillarrohre (6) zur Führung des Kühlmediums umfasst, **dadurch gekennzeichnet, dass** die Kapillarrohre aus einem Kunststoff gefertigt sind.

2. Kühlsystem nach Anspruch 1, wobei der Wärmetauscher (1) von einem flüssigen Kühlmedium, insbesondere Wasser durchströmt wird.

3. Kühlsystem nach Anspruch 1 oder 2, wobei das Kühlmedium den Wärmetauscher (1) quer zur Strömungsrichtung (S) der erwärmten Kühlluft (3) durchströmt.

4. Kühlsystem nach Anspruch 1, wobei sich die Kapillarrohre (6) in vertikaler oder in horizontaler Richtung oder in kreuzender Anordnung beider Richtungen erstrecken.

5. Kühlsystem nach Anspruch 1 oder 4, wobei mehrere parallel geschaltete Kapillarrohre (6) zu einem Verbund (7) mit einem gemeinsamen Zulauf (8) und Ablauf (9) zusammengefasst sind.

6. Kühlsystem nach Anspruch 5, wobei der Verbund (7) ein flächiger Verbund ist, der sich insbesondere quer zur Strömungsrichtung (S) der erwärmten Kühlluft (3) erstreckt.

7. Kühlsystem nach Anspruch 5 oder 6 mit mehreren zu einem Register (10) zusammengefassten Verbunden (7), die insbesondere zumindest teilweise parallel und/oder seriell geschaltet vom Kühlmedium durchströmt werden.

8. Kühlsystem nach einem der Ansprüche 1 bis 7, wobei die Kapillarrohre (6) aus Polypropylen gefertigt sind.

9. Kühlsystem nach einem der Ansprüche 1 bis 8, wobei der Wärmetauscher (1) von einem Gehäuse (11) umgeben ist, welches mit der Hausung (2) der zu kühlenden Geräte verbunden, insbesondere schwenkbar verbunden ist.

10. Kühlsystem nach Anspruch 9, wobei das Gehäuse (11) in Strömungsrichtung (S) der erwärmten Kühlluft (3) im Wesentlichen den gleiche Querschnitt aufweist wie die Hausung (2) der zu kühlenden Geräte.

## Claims

1. A cooling system for housed electronic devices, in particular computer racks, comprising a heat exchanger (1) and a closed cooling air duct (4) which extends at least between the housing (2) of the devices and the heat exchanger (1) and feeds heated cooling air (3) leaving the housing to the heat exchanger (1) before it is released to the environment (5), wherein the heat exchanger comprises capillary tubes (6) for guiding the cooling medium, **characterised in that** the capillary tubes are made of plastic.

2. The cooling system according to claim 1, wherein a liquid cooling medium, in particular water, flows through the heat exchanger (1).

3. The cooling system according to claim 1 or 2, wherein the cooling medium flows through the heat exchanger (1) transversely with respect to the flow direction (S) of the heated cooling air (3).

4. The cooling system according to claim 1, wherein the capillary tubes (6) extend in a vertical direction or in a horizontal direction or in both directions in an intersecting arrangement.

5. The cooling system according to claim 1 or 4, wherein a plurality of capillary tubes (6) connected in parallel are combined to form a composite (7) comprising a common inlet (8) and outlet (9).

6. The cooling system according to claim 5, wherein the composite (7) is a planar composite which extends in particular transversely with respect to the flow direction (S) of the heated cooling air (3).

7. The cooling system according to claim 5 or 6, comprising a plurality of composites (7) which are combined to form a register (10) and through which the cooling medium flows in particular at least partially in parallel and/or in series.

8. The cooling system according to any one of claims 1 to 7, wherein the capillary tubes (6) are made of polypropylene.

9. The cooling system according to any one of claims 1 to 8, wherein the heat exchanger (1) is surrounded by a casing (11) which is connected, in particular pivotably, to the housing (2) of the devices to be cooled.

10. The cooling system according to claim 9, wherein the casing (11) exhibits essentially the same cross-section in the flow direction (S) of the heated cooling air (3) as the housing (2) of the devices to be cooled.

## Revendications

1. Système de refroidissement pour appareils électroniques encastrés, en particulier des baies d'ordinateur, avec un échangeur de chaleur (1) et un guidage d'air de refroidissement (4) fermé et s'étendant entre le boîtier (2) des appareils et l'échangeur de chaleur (1), qui envoie l'air de refroidissement chauffé (3) sortant du boîtier à l'échangeur de chaleur (1), avant qu'il soit rejeté dans l'atmosphère (5), dans lequel l'échangeur de chaleur comprend des tubes capillaires (6) pour le guidage du fluide de refroidissement, **caractérisé en ce que** les tubes capillaires sont fabriqués en une matière synthétique.

2. Système de refroidissement selon la revendication 1, dans lequel l'échangeur de chaleur (1) est parcouru par un fluide de refroidissement liquide, en particulier par de l'eau.

3. Système de refroidissement selon la revendication 1 ou 2, dans lequel le fluide de refroidissement parcourt l'échangeur de chaleur (1) transversalement à la direction d'écoulement (S) de l'air de refroidissement chauffé (3).

4. Système de refroidissement selon la revendication 1, dans lequel les tubes capillaires (6) s'étendent en direction verticale ou horizontale ou en agencement croisé des deux directions.

5. Système de refroidissement selon la revendication 1 ou 4, dans lequel plusieurs tubes capillaires (6) montés en parallèle sont rassemblés en un faisceau (7) avec une arrivée commune (8) et une évacuation commune (9).

6. Système de refroidissement selon la revendication 5, dans lequel le faisceau (7) est un faisceau plat, qui s'étend en particulier transversalement à la direction d'écoulement (S) de l'air de refroidissement chauffé (3).

7. Système de refroidissement selon la revendication 5 ou 6 avec plusieurs faisceaux (7) rassemblés en un registre (10), qui sont parcourus par le fluide de refroidissement en étant montés en particulier au moins partiellement en parallèle et/ou en série.

8. Système de refroidissement selon l'une quelconque des revendications 1 à 7, dans lequel les tubes capillaires (6) sont fabriqués en polypropylène.

9. Système de refroidissement selon l'une quelconque des revendications 1 à 8, dans lequel l'échangeur de chaleur (1) est entouré par une enceinte (11), qui est reliée, en particulier reliée de façon pivotante, au boîtier (2) des appareils à refroidir.

10. Système de refroidissement selon la revendication 9, dans lequel l'enceinte (11) présente, dans la direction d'écoulement (S) de l'air de refroidissement chauffé (3), essentiellement la même section transversale que le boîtier (2) des appareils à refroidir.
